# EUROPEAN PATENT APPLICATION

(11) **EP 4 654 477 A1**
(43) Date of publication of application: **26.11.2025**
(21) Application number: 23917622.5
(22) Date of filing: 02.11.2023
(51) Int. Cl.: H03H 9/25, H01L 21/02, H03H 3/08

(54) **BONDED SUBSTRATE AND METHOD FOR PRODUCING BONDED SUBSTRATE**

(30) Priority: 20.01.2023 JP 2023007312
(71) Applicant: The Japan Steel Works, Ltd., Tokyo 141-0032 (JP)
(72) Inventor: MARUKO Takuya, Tokyo 141-0032 (JP); IWATA Hirokazu, Tokyo 141-0032 (JP); KIKUCHI Hirokazu, Tokyo 141-0032 (JP); CHIBA Masaki, Tokyo 141-0032 (JP); YOKOTA Hiroaki, Tokyo 141-0032 (JP)
(74) Representative: Simmons & Simmons LLP (Munich)
(86) International application number: PCT/JP2023/039668
(87) International publication number: WO 2024/154410

(57) **Abstract**

The present disclosure provides a bonded substrate having high bonding strength in which occurrence of voids is prevented. A bonded substrate (1) according to an aspect of the present disclosure is a bonded substrate in which a first substrate (10) and a second substrate (20) are bonded with a bonding surface (15) interposed therebetween. The first substrate (10) is a quartz-crystal substrate, and the second substrate (20) is a lithium tantalate substrate or a lithium niobate substrate. An intermediate layer (11 or 21) including silicon oxide is formed on a side of the bonding surface (15) of at least one of the first substrate (10) or the second substrate (20). A first modified layer (12) is formed on the side of the bonding surface (15) of the first substrate, a second modified layer (22) is formed on the side of the bonding surface (15) of the second substrate (20), and either of the modified layers (12 and 22) formed on the intermediate layers (11 and 21) of the first modified layer (12) and the second modified layer (22) has a thickness of 1.8 nm or more.

## Description

### Technical Field

The present disclosure relates to a bonded substrate and a method for producing a bonded substrate.

### Background Art

Along with the evolution of mobile communication devices such as mobile phones, there is a need for performance enhancement of surface acoustic wave (SAW) filters. Regarding surface acoustic wave elements including the SAW filters, for example, there is a need for widening of the bandwidth by improving the electromechanical coupling coefficient or reduction of the absolute value of the temperature coefficient of frequency (TCF). Patent Literature 1 discloses a technique related to a surface acoustic wave element.

### Citation List

### Patent Literature

[Patent Literature 1]
Japanese Unexamined Patent Application Publication No. 2021-158666

### Summary of Invention

### Technical Problem

For example, when a surface acoustic wave element is produced, a bonded substrate formed by bonding a first substrate formed of a quartz-crystal substrate and a second substrate formed of a lithium tantalate substrate or a lithium niobate substrate is used. However, depending on the conditions of bonding these substrates, voids may occur in the bonding surface between the first substrate and the second substrate, or the bonding strength of these substrates may be lowered. Other problems and novel characteristics will be apparent from the description of the present specification and the attached drawings.

### Solution to Problem

A bonded substrate according to an aspect of the present disclosure is a bonded substrate in which a first substrate and a second substrate are bonded with a bonding surface interposed therebetween. The first substrate is a quartz-crystal substrate, and the second substrate is a lithium tantalate substrate or a lithium niobate substrate. An intermediate layer including silicon oxide is formed on a side of the bonding surface of at least one of the first substrate or the second substrate, a first modified layer is formed on the side of the bonding surface of the first substrate, a second modified layer is formed on the side of the bonding surface of the second substrate, and either of the modified layers formed on the intermediate layers of the first modified layer and the second modified layer has a thickness of 1.8 nm or more.

A method for producing a bonded substrate according to an aspect of the present disclosure is a method for producing a bonded substrate in which a quartz-crystal substrate as a first substrate and a lithium tantalate substrate or a lithium niobate substrate as a second substrate are bonded with a bonding surface interposed therebetween,
the method including the steps of:
   (1) forming an intermediate layer including silicon oxide on a side of the bonding surface of at least one of the first substrate or the second substrate;
   (2) subjecting a surface on the side of the bonding surface of the first substrate to a plasma treatment to form a first modified layer;
   (3) subjecting a surface on the side of the bonding surface of the second substrate to a plasma treatment to form a second modified layer;
   (4) temporarily bonding the first substrate and the second substrate in a state where the first modified layer and the second modified layer face each other; and
   (5) subjecting the temporarily bonded substrate to an annealing treatment to bond the first substrate and the second substrate,
in which either of the modified layers formed on the intermediate layers of the first modified layer and the second modified layer has a thickness of 1.8 nm or more.

### Advantageous Effects of Invention

According to the present disclosure, it is possible to provide a bonded substrate having high bonding strength in which occurrence of voids is prevented, and a method for producing a bonded substrate.

### Brief Description of Drawings

Fig.1 is a cross-sectional view illustrating Configuration Example 1 of a bonded substrate according to an embodiment;
Fig. 2 is a cross-sectional view illustrating Configuration Example 2 of the bonded substrate according to the embodiment;
Fig. 3 is a cross-sectional view illustrating Configuration Example 3 of the bonded substrate according to the embodiment;
Fig. 4 is a flowchart for explaining a method for producing the bonded substrate according to the embodiment;
Fig. 5 is a schematic diagram for explaining the method for producing the bonded substrate according to the embodiment;
Fig. 6 is a schematic diagram for explaining the method for producing the bonded substrate according to the embodiment;
Fig. 7 is a graph showing a relationship between a film type of each intermediate layer (silicon oxide) and a thickness of each modified layer;
Fig. 8 is a graph showing a relationship between a film type of each intermediate layer (silicon oxide) and bonding strength; and
Fig. 9 is a graph showing a relationship between a thickness of each modified layer and bonding strength.

### Description of Embodiments

Hereinafter, an embodiment will be described with reference to the drawings.

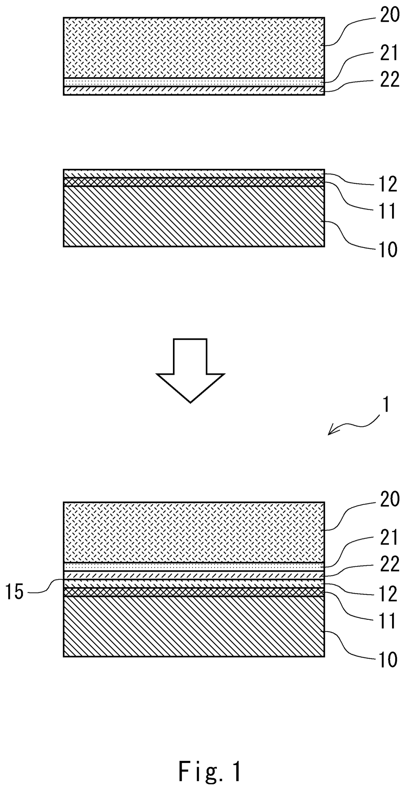

Fig.1 is a cross-sectional view showing Configuration Example 1 of a bonded substrate according to an embodiment. In Fig.1, the upper view shows a substrate before bonding, and the lower view shows a bonded substrate after bonding. As illustrated in Fig.1, a bonded substrate 1 according to the present embodiment is a bonded substrate in which a first substrate 10 and a second substrate 20 are bonded with a bonding surface 15 interposed therebetween. Here, the first substrate 10 functions as a supporting substrate, and the second substrate 20 functions as a piezoelectric element.

In the present embodiment, the first substrate 10 is a quartz-crystal substrate. The second substrate 20 is a lithium tantalate substrate or a lithium niobate substrate. The use of the quartz-crystal substrate as the first substrate 10 (supporting substrate) makes it possible to improve the temperature characteristics of the frequency of the surface acoustic wave element. In addition, the second substrate 20: the lithium tantalate substrate or the lithium niobate substrate has a high elastic wave propagation velocity and a large electromechanical coupling coefficient. Accordingly, the use of the lithium tantalate substrate or the lithium niobate substrate as the second substrate 20 (piezoelectric element) enables the bandwidth of the surface acoustic wave element to be widened.

A first intermediate layer 11 and a second intermediate layer 21 are formed as intermediate layers on the side of the bonding surface 15 of each of the first substrate 10 and the second substrate 20. Each of the first intermediate layer 11 and the second intermediate layer 21 is an intermediate layer including silicon oxide. The first intermediate layer 11 and the second intermediate layer 21 can be formed using, for example, thermal oxidation, sputtering, physical vapor deposition, and chemical vapor deposition (CVD) techniques. In particular, it is preferable to form the first intermediate layer 11 and the second intermediate layer 21 including silicon oxide by a film-forming method by which a dense film can be formed. The thicknesses of the first intermediate layer 11 and the second intermediate layer 21 can be set to 50 nm or more and 10 µm or less. In the present specification, the first intermediate layer 11 and the second intermediate layer 21 are also collectively referred to as intermediate layer(s) 11 and/or 21.

In addition, the first substrate 10 includes a first modified layer 12 on the side of the bonding surface 15. The second substrate 20 includes a second modified layer 22 on side of the bonding surface 15. That is, the first modified layer 12 is formed on a surface on the side of the bonding surface 15 of the first intermediate layer 11 formed on the first substrate 10. The second modified layer 22 is formed on a surface on the side of the bonding surface 15 of the second intermediate layer 21 formed on the second substrate 20. In the present specification, the first modified layer 12 and the second modified layer 22 are also collectively referred to as modified layers 12 and 22.

In the present embodiment, the thicknesses of the first modified layer 12 and the second modified layer 22 are 1.8 nm or more, preferably 1.8 nm or more and 2.2 nm or less. In the present embodiment, the first modified layer 12 and the second modified layer 22 are amorphous layers formed by modifying the substrate surface, and can be formed by plasma treatment, ion irradiation, or the like. That is, the first modified layer 12 and the second modified layer 22 are amorphous layers including silicon oxide as a main component and forming the first intermediate layer 11 and the second intermediate layer 21. In other words, the first modified layer 12 and the second modified layer 22 are layers including amorphous silicon oxide.

Here, the thicknesses of the first modified layer 12 and the second modified layer 22 may be different when the film-forming methods of underlying layers: the first intermediate layer 11 and the second intermediate layer 21 (in other words, the qualities of the first intermediate layer 11 and the second intermediate layer 21) are different, even in a case where the conditions of the plasma treatment and the like at the time of forming the modified layers are identical. Thus, in the present embodiment, the conditions of the plasma treatment and the like when forming the first modified layer 12 and the second modified layer 22 are changed and optimized in accordance with the film-forming method of the first intermediate layer 11 and the second intermediate layer 21 (in other words, the quality of the first intermediate layer 11 and the second intermediate layer 21). Accordingly, the thicknesses of the first modified layer 12 and the second modified layer 22 can be set to 1.8 nm or more, preferably 1.8 nm or more and 2.2 nm or less. Therefore, it is possible to form a bonded substrate having high bonding strength in which occurrence of voids is prevented.

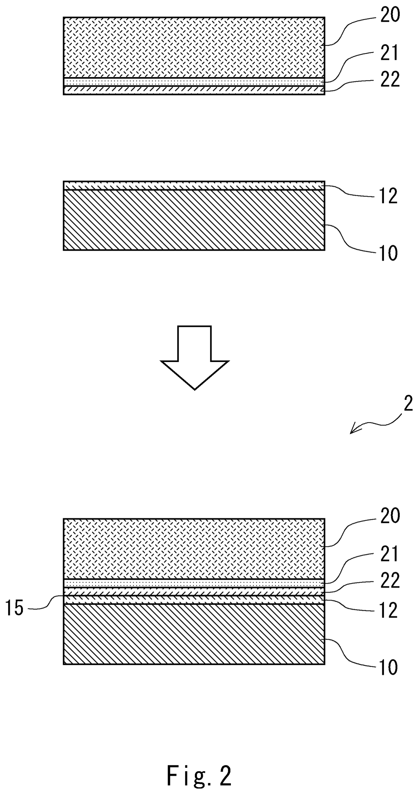

Next, Configuration Example 2 of the bonded substrate according to the present embodiment will be described. Fig. 2 is a cross-sectional view illustrating Configuration Example 2 of the bonded substrate according to the embodiment. The bonded substrate 2 according to Configuration Example 2 illustrated in Fig. 2 is different from the bonded substrate 1 according to Configuration Example 1 described in Fig.1 in that the first substrate 10 does not include the first intermediate layer 11. Configurations other than this are similar to those of the bonded substrate 1 according to Configuration Example 1 described with reference to Fig.1.

As illustrated in Fig. 2, the bonded substrate 2 according to Configuration Example 2 is a bonded substrate in which the first substrate 10 and the second substrate 20 are bonded with the bonding surface 15 interposed therebetween. The second intermediate layer 21 is formed on the second substrate 20. The first modified layer 12 is formed on a surface on the side of the bonding surface 15 of the first substrate 10. The second modified layer 22 is formed on a surface on the side of the bonding surface 15 of the second intermediate layer 21 formed on the second substrate 20.

In the bonded substrate 2 according to Configuration Example 2, the thickness of the first modified layer 12 formed on the side of the bonding surface 15 of the first substrate 10 is 2.7 nm or more and 3.2 nm or less. The thickness of the second modified layer 22 formed on the second intermediate layer 21 is 1.8 nm or more, preferably 1.8 nm or more and 2.2 nm or less.

Also in the present embodiment, the conditions of the plasma treatment and the like when forming the second modified layer 22 are changed and optimized in accordance with the film-forming method of the second intermediate layer 21 (in other words, the quality of the second intermediate layer 21). Thus, the thickness of the second modified layer 22 can be set to 1.8 nm or more, preferably 1.8 nm or more and 2.2 nm or less. Further, when the first modified layer 12 is formed on the side of the bonding surface 15 of the first substrate 10, the thickness of the first modified layer 12 is set to 2.7 nm or more and 3.2 nm or less by optimizing the conditions of the plasma treatment and the like. Therefore, it is possible to form a bonded substrate having high bonding strength in which occurrence of voids is prevented.

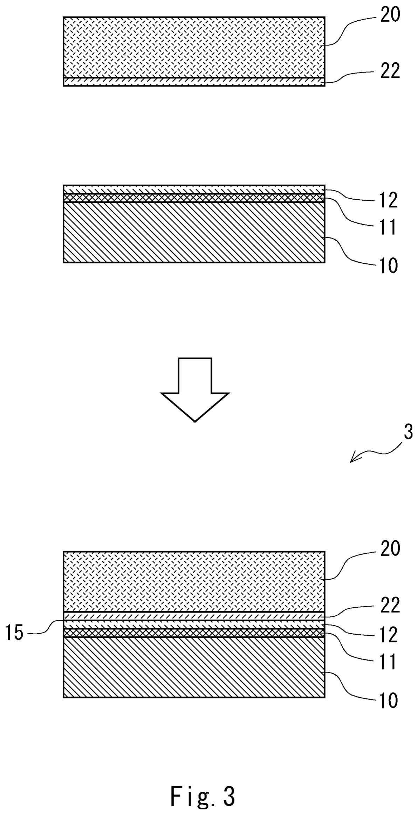

Next, Configuration Example 3 of the bonded substrate according to the present embodiment will be described. Fig. 3 is a cross-sectional view illustrating Configuration Example 3 of the bonded substrate according to the embodiment. A bonded substrate 3 according to Configuration Example 3 illustrated in Fig. 3 is different from the bonded substrate 1 according to Configuration Example 1 described in Fig.1 in that the second substrate 20 does not include the second intermediate layer 21. Configurations other than this are similar to those of the bonded substrate 1 according to Configuration Example 1 described with reference to Fig.1.

As illustrated in Fig. 3, the bonded substrate 3 according to Configuration Example 3 is a bonded substrate in which the first substrate 10 and the second substrate 20 are bonded with the bonding surface 15 interposed therebetween. The first intermediate layer 11 is formed on the first substrate 10. The first modified layer 12 is formed on a surface on the side of the bonding surface 15 of the first intermediate layer 11 formed on the first substrate 10. The second modified layer 22 is formed on a surface on the side of the bonding surface 15 of the second substrate 20.

In the bonded substrate 3 according to Configuration Example 3, the thickness of the first modified layer 12 formed on the first intermediate layer 11 is 1.8 nm or more, preferably 1.8 nm or more and 2.2 nm or less. The thickness of the second modified layer 22 formed on the side of the bonding surface 15 of the second substrate 20 is 2.2 nm or more and 2.7 nm or less.

Also in the present embodiment, the conditions of the plasma treatment and the like when forming the first modified layer 12 are changed and optimized in accordance with the film-forming method of the first intermediate layer 11 (in other words, the quality of the first intermediate layer 11). Thus, the thickness of the first modified layer 12 can be set to 1.8 nm or more, preferably 1.8 nm or more and 2.2 nm or less. Further, when the second modified layer 22 is formed on the side of the bonding surface 15 of the second substrate 20, the thickness of the second modified layer 22 is set to 2.2 nm or more and 2.7 nm or less by optimizing the conditions of the plasma treatment and the like. Therefore, it is possible to form a bonded substrate having high bonding strength in which occurrence of voids is prevented.

In the bonded substrates 1 to 3 according to Configuration Examples 1 to 3 described above, the thickness of the first substrate 10 is 100 µm or more and 1000 µm or less, and the thickness of the second substrate is 10 µm or more and 1000 µm or less. After the first substrate 10 and the second substrate 20 are bonded, the surface of the second substrate 20 may be polished. For example, the second substrate 20 may be polished so as to have a thickness of 10 µm or less.

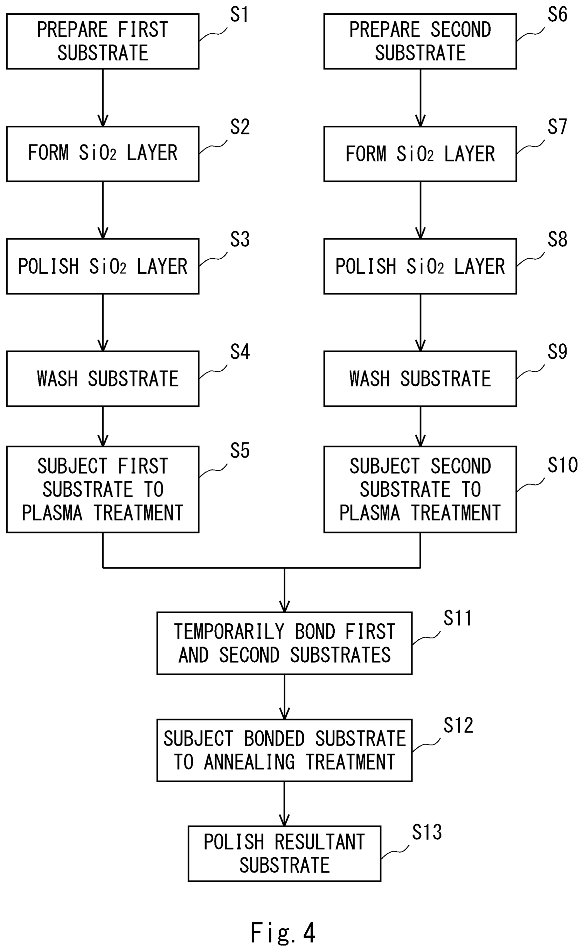

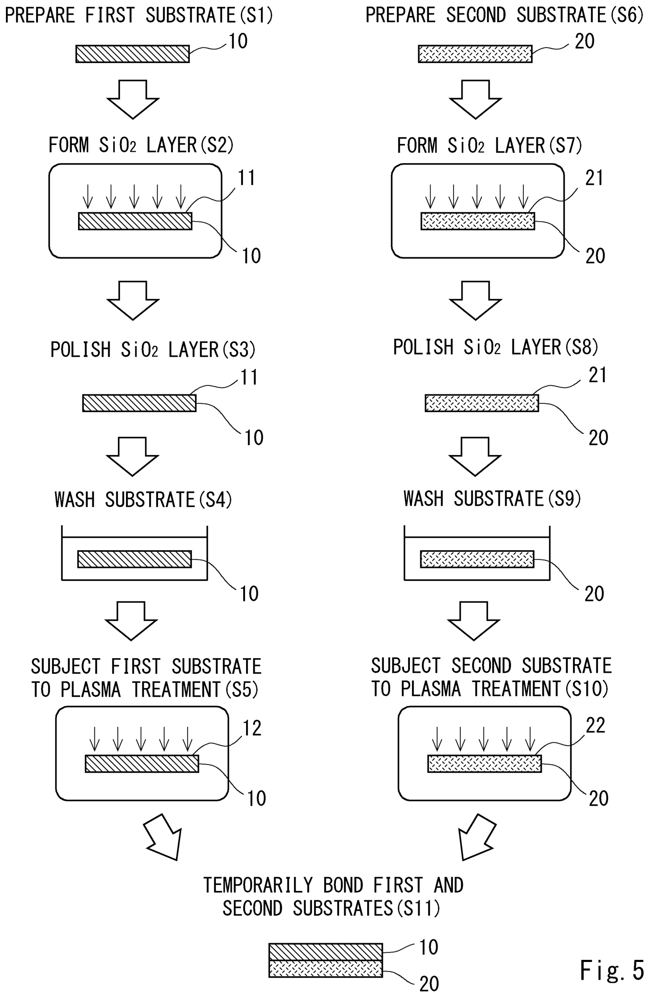

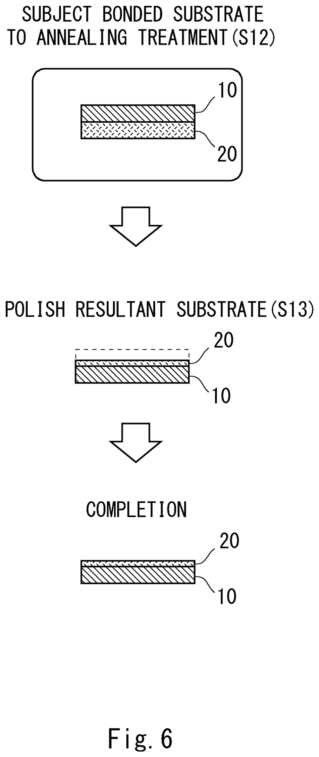

Next, a method for producing the bonded substrate according to the present embodiment will be described. Fig. 4 is a flowchart for explaining a method for producing the bonded substrate according to the present embodiment. Figs. 5 and 6 are schematic diagrams for explaining the method for producing the bonded substrate according to the present embodiment. Hereinafter, as an example, a method for producing the bonded substrate 1 according to Configuration Example 1 (i.e. a configuration in which both the first substrate 10 and the second substrate 20 include the intermediate layers 11 and 21) will be described. The bonded substrate 2 according to Configuration Example 2 and the bonded substrate 3 according to Configuration Example 3 can also be produced using a similar production method.

When the bonded substrate 1 according to the present embodiment is produced, as illustrated in Figs. 4 and 5, the first substrate 10 (quartz-crystal substrate) is first prepared (step S1). As an example, the thickness of the first substrate 10 (quartz-crystal substrate) is 100 µm or more and 1000 µm or less. Next, a silicon oxide (SiO₂) layer, which is the first intermediate layer 11, is formed on the surface of the first substrate 10 (step S2). The first intermediate layer 11 can be formed by using, for example, thermal oxidation, sputtering, physical vapor deposition, and chemical vapor deposition (CVD) techniques. In particular, it is preferable to form the first intermediate layer 11 by a film-forming method by which a dense film can be formed. The thickness of the first intermediate layer 11 can be set to 50 nm or more and 10 µm or less. Thereafter, the formed first intermediate layer 11 is polished (step S3). Polishing of the surface of the first intermediate layer 11 in this manner enables the surface of the first intermediate layer 11 to be made flat.

Next, the polished first substrate 10 is washed (step S4). For example, the polished first substrate 10 is washed with a chemical solution such as an ammonium hydrogen peroxide mixture (APM) or a sulfuric acid-hydrogen peroxide mixture (SPM). Next, the surface on the side of the first intermediate layer 11 of the first substrate 10 is subjected to a plasma treatment (step S5). Subjecting the surface on the side of the first intermediate layer 11 of the first substrate 10 to the plasma treatment makes it possible to form the first modified layer 12 on the surface of the first substrate 10 (the first intermediate layer 11). The thickness of the first modified layer 12 to be formed on the surface of the first substrate 10 (the first intermediate layer 11) is 1.8 nm or more, preferably 1.8 nm or more and 2.2 nm or less.

In the present embodiment, subjecting the first substrate 10 to the plasma treatment under conditions that plasma emission is stable (conditions that a variation in plasma emission is small) makes it possible to reduce a variation in the in-plane film thickness of the first modified layer 12 formed on the surface of the first substrate 10 (the first intermediate layer 11). The variation in plasma emission can be reduced by adjusting the pressure in a chamber of a plasma treatment apparatus and the plasma output (RF output).

Next, the second substrate 20 (a lithium tantalate substrate or a lithium niobate substrate) is prepared (step S6). As an example, the thickness of the second substrate 20 is 100 µm or more and 1000 µm or less. Next, a silicon oxide (SiO₂) layer, which is the second intermediate layer 21, is formed on the surface of the second substrate 20 (step S7). The second intermediate layer 21 can be formed by using, for example, thermal oxidation, sputtering, physical vapor deposition, and chemical vapor deposition (CVD) techniques. In particular, it is preferable to form the second intermediate layer 21 by a film-forming method by which a dense film can be formed. The thickness of the second intermediate layer 21 can be set to 50 nm or more and 10 µm or less. Thereafter, the formed second intermediate layer 21 is polished (step S8). As described above, polishing of the surface of the second intermediate layer 21 in this manner enables the surface of the second intermediate layer 21 to be made flat.

Next, the polished second substrate 20 is washed (step S9). For example, the polished second substrate 20 is washed with a chemical solution such as APM or SPM. Next, the surface on the side of the second intermediate layer 21 of the second substrate 20 is subjected to a plasma treatment (step S10). Subjecting the surface of the second substrate 20 on the side of the second intermediate layer 21 to the plasma treatment makes it possible to form the second modified layer 22 on the surface of the second substrate 20 (the second intermediate layer 21). The thickness of the second modified layer 22 to be formed on the surface of the second substrate 20 (the second intermediate layer 21) is 1.8 nm or more, preferably 1.8 nm or more and 2.2 nm or less.

In the present embodiment, subjecting the second substrate 20 to the plasma treatment under conditions that plasma emission is stable (conditions that a variation in plasma emission is small) makes it possible to reduce a variation in the in-plane film thickness of the second modified layer 22 formed on the surface of the second substrate 20 (the second intermediate layer 21). The variation in plasma emission can be reduced by adjusting the pressure in a chamber of a plasma treatment apparatus and the plasma output (RF output).

Note that the order of the treatments of steps S1 to S5 and the treatments of steps S6 to S10 may be reversed. That is, the treatments of steps S6 to S10 are performed, and then the treatments of steps S1 to S5 may be performed. Alternatively, the treatments of steps S1 to S5 and the treatments of steps S6 to S10 may be performed in parallel (simultaneously).

Next, the first substrate 10 and the second substrate 20 are temporarily bonded in a state where the first modified layer 12 of the first substrate 10 and the second modified layer 22 of the second substrate 20 face each other (step S11). For example, the positions (positions in a horizontal direction) in an in-plane direction of the first substrate 10 and the second substrate 20 are adjusted, and then the first substrate 10 and the second substrate 20 are moved in a vertical direction to temporarily bond the first substrate 10 and the second substrate 20.

Thereafter, as illustrated in Figs. 4 and 6, the temporarily bonded substrate is subjected to an annealing treatment to bond the first substrate 10 and the second substrate 20 (step S12). The annealing treatment is carried out, as a result of which the first modified layer 12 of the first substrate 10 and the second modified layer 22 of the second substrate 20 can be firmly bonded, and the first substrate 10 and the second substrate 20 can be firmly bonded. For example, the temperature of the annealing treatment is 50°C or higher and 300°C or lower. The annealing treatment can be performed, for example, by putting the temporarily bonded substrate in an electric furnace and heating the substrate.

The present embodiment may further include a step (step S13) of polishing the surface of the second substrate 20 after bonding the first substrate 10 and the second substrate 20. The polishing step can be performed using, for example, chemical mechanical polishing (CMP). For example, the second substrate 20 is polished so as to have a thickness of 10 µm or less.

The use of the production method (the method of bonding the substrates) described above makes it possible to produce the bonded substrate according to the present embodiment.

In the present embodiment, the thickness of the first modified layer 12 of the first substrate 10 and the thickness of the second modified layer 22 of the second substrate 20 can be measured using a transmission electron microscope (TEM).

For example, the thicknesses of the first modified layer 12 and the second modified layer 22 are measured using a transmission electron microscope and the conditions of the plasma treatment are changed according to the measured thicknesses of the first modified layer 12 and the second modified layer 22, as a result of which it is possible to form the first modified layer 12 and the second modified layer 22 having thicknesses in the above ranges.

In the present embodiment, the thicknesses of the first modified layer 12 and the second modified layer 22 of the bonded substrate 1 after bonding can be measured using the transmission electron microscope. In the present embodiment, it is considered that the relationship between the thickness of the first modified layer 12 and the thickness of the second modified layer 22 does not change before and after the bonding of the first substrate 10 and the second substrate 20.

When the bonded substrate 2 according to Configuration Example 2 (i.e. a configuration in which only the second substrate 20 includes the intermediate layer 21) is produced, steps S2 and S3 illustrated in Figs. 4 and 5 are omitted. Also, when the bonded substrate 3 according to Configuration Example 3 (i.e. a configuration in which only the first substrate 10 includes the intermediate layer 11) is produced, steps S7 and S8 illustrated in Figs. 4 and 5 are omitted. The other production steps are similar to the production steps of the bonded substrate 1 according to Configuration Example 1.

In the meantime, the inventors of the present application have found that the thicknesses of the first modified layer 12 and the second modified layer 22 vary depending on the film types of the first intermediate layer 11 and the second intermediate layer 21 formed on the surfaces of the first substrate 10 and the second substrate 20, respectively. That is, it has been found that the thicknesses of the first modified layer 12 and the second modified layer 22 vary depending on the film types of the first intermediate layer 11 and the second intermediate layer 21 even when the plasma treatment is carried out under the same conditions.

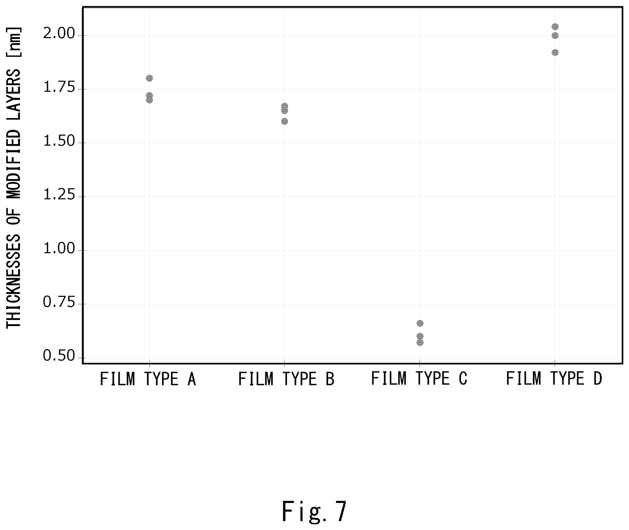

Fig. 7 is a graph showing a relationship between a film type of each intermediate layer (silicon oxide) and a thickness of each modified layer. Film types A to D shown in Fig. 7 were formed using different vapor phase methods. Then, the intermediate layers (silicon oxide) of film types A to D were subjected to a plasma treatment under the same conditions to form modified layers, and the film thicknesses of the modified layers were measured. As a result, even when the plasma treatment was carried out under the same conditions, the thicknesses of the modified layers varied depending on the film type of each of the intermediate layers (silicon oxide). Specifically, the thickness of the modified layer of film type D was the thickest among all. The thickness of the modified layer of film type A was the same as the thickness of the modified layer of film type B. The thickness of the modified layer of film type C was the thinnest among all. There was a large difference of about 1.4 nm in thickness between the modified layer of film type D and the modified layer of film type C.

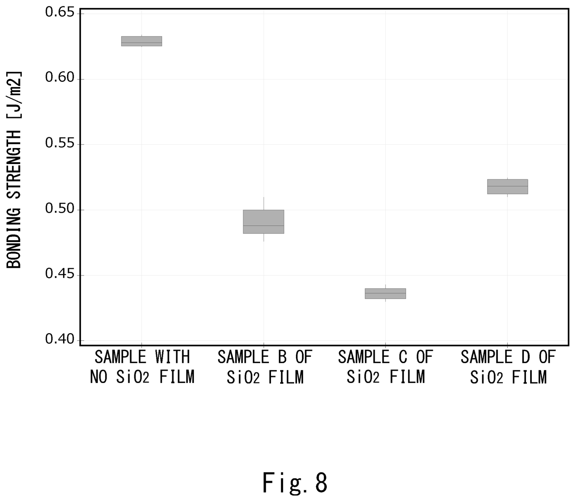

Fig. 8 is a graph showing a relationship between a film type of each intermediate layer (silicon oxide) and bonding strength. Fig. 8 shows the bonding strength in the absence of the intermediate layer (silicon oxide), the bonding strength in the case of the intermediate layer (silicon oxide) of film type B, the bonding strength in the case of the intermediate layer (silicon oxide) of film type C, and the bonding strength in the case of the intermediate layer (silicon oxide) of film type D. As shown in Fig. 8, in each of the case where there is no intermediate layer (silicon oxide) and the cases of the intermediate layers (silicon oxide) of film types B to D, the bonding strength varied.

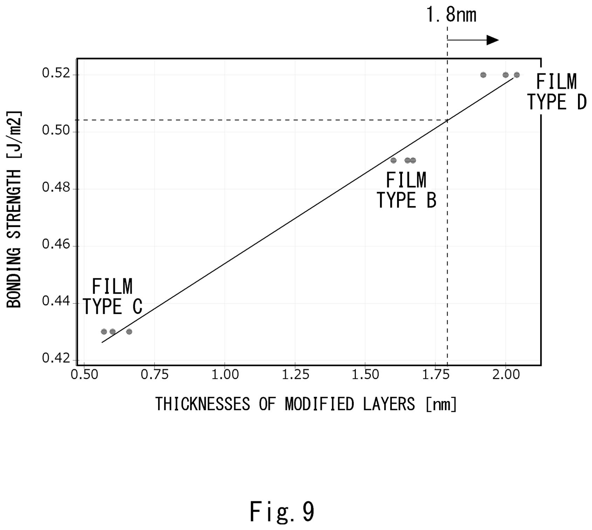

Fig. 9 is a graph showing a relationship between a thickness of each modified layer and bonding strength. Fig. 9 shows the relationship between the thickness of each of the modified layers formed on the intermediate layers of film types B to D and the bonding strength. As shown in Fig. 9, the thickness of each of the modified layers was positively correlated with the bonding strength. As shown in Fig. 9, it was found that the thickness of each of the modified layers needed to be 1.8 nm or more in order to achieve higher bonding strength than 0.50.

In the bonded substrate according to the present embodiment, setting the thickness of the modified layer formed on the surface of the intermediate layer (silicon oxide) to 1.8 nm or more makes it possible to form a bonded substrate having high bonding strength in which occurrence of voids is prevented. In addition, increasing the bonding strength of the bonded substrate makes it possible to prevent peeling of the bonded substrate in the polishing step.

Specifically, in the bonded substrate 1 according to Configuration Example 1 illustrated in Fig.1, the first intermediate layer 11 and the second intermediate layer 21 are provided on both the first substrate 10 and the second substrate 20, respectively. Accordingly, setting the thicknesses of the first modified layer 12 and the second modified layer 22 formed on the surfaces of the first intermediate layer 11 and the second intermediate layer 21 to 1.8 nm or more, respectively makes it possible to increase the bonding strength of the bonded substrate while preventing the occurrence of voids. That is, in the bonded substrate 1 according to Configuration Example 1 illustrated in Fig.1, since the intermediate layers (silicon oxide) 11 and 21 are formed on both the first substrate 10 and the second substrate 20, the film thicknesses of the modified layers 12 and 22 formed on the surfaces of the intermediate layers (silicon oxide) 11 and 21 are set to 1.8 nm or more.

In the bonded substrate 2 according to Configuration Example 2 illustrated in Fig. 2, the second intermediate layer 21 is provided on the second substrate 20. Accordingly, setting the thickness of the second modified layer 22 formed on the surface of the second intermediate layer 21 to 1.8 nm or more makes it possible to increase the bonding strength of the bonded substrate while preventing the occurrence of voids. That is, in the bonded substrate 2 according to Configuration Example 2 illustrated in Fig. 2, since the intermediate layer (silicon oxide) 21 is formed only on the second substrate 20, the film thickness of the modified layer 22 formed on the surface of the intermediate layer (silicon oxide) 21 of the second substrate 20 is set to 1.8 nm or more. In this case, the thickness of the first modified layer 12 formed on the side of the bonding surface 15 of the first substrate 10 is set to 2.7 nm or more and 3.2 nm or less.

In the bonded substrate 3 according to Configuration Example 3 illustrated in Fig. 3, the first intermediate layer 11 is provided on the first substrate 10. Accordingly, setting the thickness of the first modified layer 12 formed on the surface of the first intermediate layer 11 to 1.8 nm or more makes it possible to increase the bonding strength of the bonded substrate while preventing the occurrence of voids. That is, in the bonded substrate 3 according to Configuration Example 3 illustrated in Fig. 3, since the intermediate layer (silicon oxide) 11 is formed only on the first substrate 10, the film thickness of the modified layer 12 formed on the surface of the intermediate layer (silicon oxide) 11 of the first substrate 10 is set to 1.8 nm or more. In this case, the thickness of the second modified layer 22 formed on the side of the bonding surface 15 of the second substrate 20 is set to 2.2 nm or more and 2.7 nm or less.

The film thicknesses of the modified layers 12 and 22 can be adjusted by changing the conditions of the plasma treatment and the like according to the film types of the intermediate layers 11 and 21.

In addition, in the present embodiment, forming the intermediate layers 11 and 21 on the surface of at least one of the first substrate 10 or the second substrate 20 makes it possible to cancel the influence of the first substrate 10 and the second substrate 20, i.e. the influence of the first substrate 10 and the second substrate 20 on the modified layers 12 and 22. Accordingly, it is possible to expand options of the first substrate 10 and the second substrate 20. The film thicknesses of the modified layers 12 and 22 can be adjusted by changing the conditions of the plasma treatment and the like according to the film types of the intermediate layers 11 and 21, and thus it is possible to easily set conditions for forming the desired modified layers 12 and 22.

### Examples

Subsequently, Examples will be described.

### <Production of Sample>

Respective samples were produced using the method described in Figs. 4 to 6. Specifically, the bonded substrate 2 according to Configuration Example 2 illustrated in Fig. 2 (i.e. a configuration in which only the second substrate 20 includes the intermediate layer 21) was produced. When the bonded substrate 2 according to Configuration Example 2 is produced, steps S2 and S3 illustrated in Figs. 4 and 5 are omitted.

First, a quartz-crystal substrate having a thickness of 400 µm was prepared as the first substrate 10. Next, the quartz-crystal substrate was washed by immersion in an APM solution for 10 minutes.

Then, the quartz-crystal substrate was subjected to a plasma treatment to form a modified layer having a thickness of 3.0 nm on the surface of the quartz-crystal substrate. The plasma treatment was carried out by generating capacitively coupled plasma under a reduced-pressure atmosphere. As for conditions of the plasma treatment, the RF output was set to 100 W, and the treatment time was adjusted such that the film thickness of the modified layer was 3.0 nm.

In addition, a lithium tantalate substrate (LT substrate) having a thickness of 200 µm was prepared as the second substrate 20. Next, a silicon oxide (SiO₂) layer as an intermediate layer (second intermediate layer) was formed on the surface of the lithium tantalate substrate. As the intermediate layer, intermediate layers of four film types were formed. Film types A to D were formed using different vapor phase methods. Samples of different film types are hereinafter referred to as samples A to D, respectively. The thickness of each of the intermediate layers was 800 nm. Thereafter, the formed intermediate layers were polished.

Next, the polished lithium tantalate substrate was washed by immersion in an APM solution for 10 minutes. Next, the lithium tantalate substrate was subjected to a plasma treatment to form a modified layer on the surface of the intermediate layer of the lithium tantalate substrate. The plasma treatment was carried out by generating capacitively coupled plasma under a reduced-pressure atmosphere. As for the conditions of the plasma treatment, the RF output was set to 100 W. In samples A to D, the plasma treatment was performed under the same conditions.

Next, the quartz-crystal substrate and the lithium tantalate substrate were brought into contact with each other in a state where the modified layer of the quartz-crystal substrate and the modified layer of the lithium tantalate substrate faced each other, and thus the substrates were temporarily bonded. Thereafter, the temporarily bonded substrate was subjected to an annealing treatment at 150°C, and the quartz-crystal substrate was bonded with the lithium tantalate substrate to form a bonded substrate.

In addition, a sample (with no intermediate layer) in which an intermediate layer was not formed on the surface of the lithium tantalate substrate was separately produced.

### <Evaluation of Samples>

After the modified layer was formed on the surface of the intermediate layer of the lithium tantalate substrate, the film thickness of the modified layer of each of samples A to D was measured. The film thickness of the modified layer was measured using a transmission electron microscope. Fig. 7 is a graph showing a relationship between film types A to D of the intermediate layers (silicon oxide) and the thicknesses of the modified layers. As illustrated in Fig. 7, even when the plasma treatment was carried out under the same conditions, the thicknesses of the modified layers varied depending on film types A to D of intermediate layers (silicon oxide). Specifically, the thickness of the modified layer of film type D was the thickest among all. The thickness of the modified layer of film type A was the same as the thickness of the modified layer of film type B. The thickness of the modified layer of film type C was the thinnest among all. There was a large difference of about 1.4 nm in thickness between the modified layer of film type D and the modified layer of film type C.

In addition, the bonding strength was examined for samples A to D produced as described above and the sample with no intermediate layer (SiO₂ film). The bonding strength was measured using a blade method. As an evaluation method of the blade method, a method similar to the method described in the reference literature (Materials Science and Engineering R25 (1999) p. 1-88) was used.

Fig. 8 shows the bonding strength of the sample with no intermediate layer (SiO₂ film) and the bonding strength of samples B to D. As illustrated in Fig. 8, the bonding strength of the sample with no intermediate layer (SiO₂ film) and the bonding strength of samples B to D varied.

Fig. 9 is a graph showing a relationship between the thickness of each of the modified layers of samples B to D and the bonding strength. As shown in Fig. 9, the thickness of each of the modified layers was positively correlated with the bonding strength. As shown in Fig. 9, it was found that the thickness of each of the modified layers needed to be 1.8 nm or more in order to achieve higher bonding strength than 0.50.

In addition, the presence or absence of occurrence of voids was examined for samples A to D produced as described above. The presence or absence of voids was examined using a differential interference contrast optical microscope. As a result, the degree of occurrence of voids in samples A to D was equal to or less than the reference value, and the occurrence of voids could be prevented.

From the above results, in sample D in which the thickness of the modified layer was 1.8 nm or more, the bonding strength could be set to the reference value or more while preventing the occurrence of voids.

Although the invention made by the present inventors has been specifically described based on the embodiment, the present invention is not limited to the above embodiment, and it goes without saying that various modifications can be made without departing from the gist of the present invention.

This application claims priority based on Japanese Patent Application No. 2023-7312 filed on January 20, 2023, the entire disclosure of which is incorporated herein by reference.

### Reference Signs List

- 1, 2, 3: BONDED SUBSTRATE
- 10: FIRST SUBSTRATE
- 11: FIRST INTERMEDIATE LAYER
- 12: FIRST MODIFIED LAYER
- 15: BONDING SURFACE
- 20: SECOND SUBSTRATE
- 21: SECOND INTERMEDIATE LAYER
- 22: SECOND MODIFIED LAYER

## Claims

1. A bonded substrate in which a first substrate and a second substrate are bonded with a bonding surface interposed therebetween, wherein
the first substrate is a quartz-crystal substrate,
the second substrate is a lithium tantalate substrate or a lithium niobate substrate,
an intermediate layer including silicon oxide is formed on a side of the bonding surface of at least one of the first substrate or the second substrate,
a first modified layer is formed on the side of the bonding surface of the first substrate,
a second modified layer is formed on the side of the bonding surface of the second substrate, and
either of the modified layers formed on the intermediate layers of the first modified layer and the second modified layer has a thickness of 1.8 nm or more.

2. The bonded substrate according to claim 1, wherein
a first intermediate layer and a second intermediate layer are formed as the intermediate layers on the side of the bonding surface of each of the first substrate and the second substrate,
the first modified layer is formed on a surface on a side of the bonding surface of the first intermediate layer formed on the first substrate,
the second modified layer is formed on a surface on a side of the bonding surface of the second intermediate layer formed on the second substrate,
the first modified layer formed on the first intermediate layer has a thickness of 1.8 nm or more and 2.2 nm or less, and
the second modified layer formed on the second intermediate layer has a thickness of 1.8 nm or more and 2.2 nm or less.

3. The bonded substrate according to claim 1, wherein
a second intermediate layer is formed as the intermediate layer on the second substrate,
the first modified layer is formed on a surface on a side of the bonding surface of the first substrate,
the second modified layer is formed on a surface on a side of the bonding surface of the second intermediate layer formed on the second substrate,
the first modified layer formed on the side of the bonding surface of the first substrate has a thickness of 2.7 nm or more and 3.2 nm or less, and
the second modified layer formed on the second intermediate layer has a thickness of 1.8 nm or more and 2.2 nm or less.

4. The bonded substrate according to claim 1, wherein
a first intermediate layer is formed as the intermediate layer on the first substrate,
the first modified layer is formed on a surface on the side of the bonding surface of the first intermediate layer formed on the first substrate,
the second modified layer is formed on a surface on the side of the bonding surface of the second substrate,
the first modified layer formed on the first intermediate layer has a thickness of 1.8 nm or more and 2.2 nm or less, and
the second modified layer formed on the side of the bonding surface of the second substrate has a thickness of 2.2 nm or more and 2.7 nm or less.

5. The bonded substrate according to claim 1, wherein the intermediate layer has a thickness of 50 nm or more and 10 µm or less.

6. The bonded substrate according to claim 1, wherein
the first substrate has a thickness of 100 µm or more and 1000 µm or less, and
the second substrate has a thickness of 10 µm or more and 1000 µm or less.

7. A method for producing a bonded substrate in which a quartz-crystal substrate as a first substrate and a lithium tantalate substrate or a lithium niobate substrate as a second substrate are bonded with a bonding surface interposed therebetween,
the method comprising the steps of:
(1) forming an intermediate layer including silicon oxide on a side of the bonding surface of at least one of the first substrate or the second substrate;
(2) subjecting a surface on the side of the bonding surface of the first substrate to a plasma treatment to form a first modified layer;
(3) subjecting a surface on the side of the bonding surface of the second substrate to a plasma treatment to form a second modified layer;
(4) temporarily bonding the first substrate and the second substrate in a state where the first modified layer and the second modified layer face each other; and
(5) subjecting the temporarily bonded substrate to an annealing treatment to bond the first substrate and the second substrate,
wherein either of the modified layers formed on the intermediate layers of the first modified layer and the second modified layer has a thickness of 1.8 nm or more.

8. The method for producing a bonded substrate according to claim 7,
wherein
in the step (1), a first intermediate layer and a second intermediate layer each including silicon oxide are formed on the side of the bonding surface of each of the first substrate and the second substrate,
in the step (2), a surface on the side of the bonding surface of the first intermediate layer formed on the first substrate is subjected to a plasma treatment to form the first modified layer,
in the step (3), a surface on the side of the bonding surface of the second intermediate layer formed on the second substrate is subjected to a plasma treatment to form the second modified layer,
a thickness of the first modified layer formed on the first intermediate layer is set to 1.8 nm or more and 2.2 nm or less, and
a thickness of the second modified layer formed on the second intermediate layer is set to 1.8 nm or more and 2.2 nm or less.

9. The method for producing a bonded substrate according to claim 7,
wherein
in the step (1), a second intermediate layer including silicon oxide is formed on the side of the bonding surface of the second substrate,
in the step (2), a surface on the side of the bonding surface of the first substrate is subjected to a plasma treatment to form the first modified layer,
in the step (3), a surface on the side of the bonding surface of the second intermediate layer formed on the second substrate is subjected to a plasma treatment to form the second modified layer,
a thickness of the first modified layer formed on the side of the bonding surface of the first substrate is set to 2.7 nm or more and 3.2 nm or less, and
a thickness of the second modified layer formed on the second intermediate layer is set to 1.8 nm or more and 2.2 nm or less.

10. The method for producing a bonded substrate according to claim 7,
wherein
in the step (1), a first intermediate layer including silicon oxide is formed on the side of the bonding surface of the first substrate,
in the step (2), a surface on the side of the bonding surface of the first intermediate layer formed on the first substrate is subjected to a plasma treatment to form the first modified layer,
in the step (3), a surface on the side of the bonding surface of the second substrate is subjected to a plasma treatment to form the second modified layer,
a thickness of the first modified layer formed on the first intermediate layer is set to 1.8 nm or more and 2.2 nm or less, and
a thickness of the second modified layer formed on the side of the bonding surface of the second substrate is set to 2.2 nm or more and 2.7 nm or less.

11. The method for producing a bonded substrate according to claim 7,
wherein a temperature of the annealing treatment is 50°C or higher and 300°C or lower.

12. The method for producing a bonded substrate according to claim 7,
wherein
the first substrate has a thickness of 100 µm or more and 1000 µm or less, and
the second substrate has a thickness of 10 µm or more and 1000 µm or less.

13. The method for producing a bonded substrate according to claim 7, further comprising a step of polishing a surface of the second substrate on a side opposite to a side on which the second modified layer is formed after bonding the first substrate and the second substrate.

14. The method for producing a bonded substrate according to claim 13,
wherein the second substrate is polished so as to have a thickness of 10 µm or less.
